# EUROPÄISCHE PATENTSCHRIFT

(11) **EP 0 776 477 B1**
(45) Veröffentlichungstag und Bekanntmachung des Hinweises auf die Patenterteilung: **20.05.1998**
(21) Anmeldenummer: 95928432.4
(22) Anmeldetag: 16.08.1995
(51) Int. Cl.: G01R 15/24

(54) **VERFAHREN UND ANORDNUNG ZUM MESSEN VON ELEKTRISCHEN STRÖMEN AUS WENIGSTENS ZWEI MESSBEREICHEN**
METHOD AND DEVICE FOR THE MEASUREMENT OF ELECTRIC CURRENTS IN AT LEAST TWO MEASUREMENT RANGES
PROCEDE ET SYSTEME PERMETTANT DE MESURER DES COURANTS ELECTRIQUES DANS AU MOINS DEUX PLAGES DE MESURE

(30) Priorität: 23.08.1994 DE 4429909; 05.09.1994 DE 4431615
(43) Veröffentlichungstag der Anmeldung: 04.06.1997
(73) Patentinhaber: SIEMENS AKTIENGESELLSCHAFT, 80333 München (DE)
(72) Erfinder: BOSSELMANN, Thomas, D-91054 Erlangen (DE); BARTELT, Hartmut, D-91056 Erlangen (DE)
(86) Internationale Anmeldenummer: DE9501079
(87) Internationale Veröffentlichungsnummer: WO9606359

(56) Entgegenhaltungen:
- EP-A- 0 088 419
- DE-A- 3 141 325
- OPTICS LETTERS, Bd. 16, Nr. 12, 15.Juni 1991 WASHINGTON US, Seiten 955-957, BUSH ET AL. 'DUAL-CHANNEL FARADAY-EFFECT CURRENT SENSOR...'
- PATENT ABSTRACTS OF JAPAN vol. 8 no. 137 (P-282) [1574] ,26.Juni 1984 & JP,A,59 037461 (HITACHI) 29.Februar 1984,

## Beschreibung

Die Erfindung betrifft ein Verfahren und eine Anordnung zum Messen von Strömen aus wenigstens zwei Meßbereichen in einem Stromleiter.

Es sind optische Meßanordnungen zum Messen eines elektrischen Stromes in einem Stromleiter unter Ausnutzung des Faraday-Effekts bekannt, die auch als magnetooptische Stromwandler bezeichnet werden. Unter dem Faraday-Effekt versteht man die Drehung der Polarisationsebene von linear polarisiertem Licht in Abhängigkeit von einem Magnetfeld. Der Drehwinkel ist dabei proportional zum Wegintegral über das Magnetfeld entlang des von dem Licht zurückgelegten Weges mit der sogenannten Verdet-Konstanten als Proportionalitätskonstante. Die Verdet-Konstante ist im allgemeinen material-, temperatur- und wellenlängenabhangig. Zum Messen des Stromes ist ein Faraday-Element aus einem optisch transparenten Material wie beispielsweise einem Glas in der Nähe des Stromleiters angeordnet. Das von dem Strom erzeugte Magnetfeld bewirkt eine Drehung der Polarisationsebene von durch das Faraday-Element gesendetem linear polarisiertem Licht um einen Drehwinkel, der als Meßsignal ausgewertet werden kann. Im allgemeinen umgibt das Faraday-Element den Stromleiter, so daß das Meßlicht den Stromleiter in einem weitgehend geschlossenen Weg umläuft. Der Betrag des Drehwinkels ist in diesem Fall in guter Näherung direkt proportional zur Amplitude des zu messenden Stromes. Das Faraday-Element kann als massiver Glasring um den Stromleiter ausgebildet sein, der von dem Licht nur einmal durchlaufen wird, oder auch den Stromleiter in Form einer Meßwicklung aus einer lichtleitenden Monomode-Faser umgeben (Faserspule). Bei einem massiven Faraday-Element wird der Meßbereich des Stromwandlers durch eine geeignete Wahl des Materials eingestellt, wobei für größere Ströme ein Material mit einer kleineren Verdet-Konstanten als für kleinere Ströme verwendet wird. Im Falle einer Meßwicklung kann der Meßbereich des Stromwandlers zusätzlich durch die Zahl der Windungen der Meßwicklung eingestellt werden, denn der Faraday-Drehwinkel ist auch proportional zur Zahl der Windungen und damit der Umläufe des Lichts um den Stromleiter. Als Meßbereich wird in beiden Fällen ein Strombereich ausgewählt, über dem der Faraday-Drehwinkel eine eindeutige Funktion des Stromes ist. Da zwei antiparallel zueinander gerichtete, d.h. um einen Winkel von π gegeneinander gedrehte Polariationszustände des Meßlichts meßtechnisch nicht unterschieden werden können, entspricht der Meßbereich des magnetooptischen Stromwandlers einem Drehwinkelintervall von maximal π/2 Intervallänge.

Bei einem aus EP-B-0 088 419 bekannten magnetooptischen Stromwandler sind zwei Faraday-Glasringe parallel zueinander um einen gemeinsamen Stromleiter angeordnet. Die beiden Glasringe bestehen aus Faraday-Materialien mit unterschiedlicher Meßempfindlichkeit und weisen damit unterschiedliche Strommeßbereiche auf. Jedem Faraday-Glasring sind jeweils eine Sendeeinheit zum Senden linear polarisierten Meßlichts in den Glasring, jeweils ein Rochon-Prisma, ein Wollaston-Prisma oder ein anderer polarisierender Strahlteiler als Analysator zum Aufteilen des nach Durchlaufen des jeweiligen Faraday-Glasrings um einen jeweiligen Faraday-Meßwinkel gedrehten Meßlichts in zwei Lichtteilstrahlen mit unterschiedlichen Polarisationsebenen, Photodioden zum Umwandeln der jeweiligen Lichtteilsignale in elektrische Signale sowie jeweils eine Auswerteeinheit zum Berechnen eines jeweiligen Meßsignals für den jeweiligen Faraday-Drehwinkel zugeordnet. Die beiden Meßsignale der beiden Faraday-Glasringe werden einem OR-Gatter zugeführt, das ein Maximumssignal aus den beiden Meßsignale ermittelt. Mit diesem Maximumssignal kann ein größerer Meßbereich abgedeckt werden. Unterschiedliche Meßbereiche der beiden Glasringe können auch bei gleichem Glasmaterial für beide Glasringe erreicht werden, indem Meßlicht unterschiedlicher Wellenlänge verwendet wird. Dabei wird die Wellenlangenabhängigkeit der Faraday-Drehung ausgenutzt.

Für die moderne Meßpraxis sollten Stromwandler für Meß- und Zähleranwendungen Nennströme in einem vorgegebenen Meßbereich von beispielsweise bis zu 2000 A mit einer hohen Meßgenauigkeit von typischerweise zwischen etwa 0.1 % und etwa 0.5 % und für Schutzzwecke Überströme in einem Meßbereich von beispielsweise dem 10 fachen bis 30fachen des Nennstroms mit einer geringeren Meßgenauigkeit von im allgemeinen zwischen etwa 5 % und etwa 10 % erfassen können.

Aus "International Conference of Large High Voltage Electric Systems", CIGRE, Paris, 28.8.-3.9.1988, Conference Proceedings, T, Pref. Subj. 1, Vol. 34, Band 15, Seiten 1 bis 10 ist eine faseroptische Meßanordnung mit einem ersten magnetooptischen Stromwandler zum Messen von Nennströmen in einem Meßbereich zwischen dem 0,1 fachen und dem 1 fachen eines vorgegebenen Maximalnennstromes mit einer Meßgenauigkeit von 0,2% und mit einem zweiten magnetooptischen Stromwandler zum Messen von Überströmen in einem Meßbereich zwischen dem 0,1fachen und dem 20fachen des Maximalnennstromes mit einer Meßgenauigkeit von 5% bekannt. Der erste Stromwandler zum Messen von Nennströmen ist vom Reflexionstyp und umfaßt eine optische Faser, die den Stromleiter in Form einer Meßwicklung mit N Windungen umgibt. Über einen Strahlteiler wird in einem Polarisator linear polarisiertes Licht einer Lichtquelle in die Faser eingekoppelt, durchläuft die Meßwicklung, wird von einem Spiegel in die Faser zurückreflektiert und durchläuft die Meßwicklung in umgekehrter Richtung ein zweites Mal. Wegen der Nicht-Reziprokitat des Faraday-Effekts wird der Drehwinkel verdoppelt. Wegen der Reziprokität der intrinsischen zirkularen Doppelbrechung des Fasermaterials heben sich die unerwünschten und insbesondere temperaturabhängigen Effekte der zirkularen Doppelbrechung dagegen gerade heraus. Über den Strahlteiler wird das Licht nach zweimaligem Durchlaufen der Meßwicklung einem Wollaston-Prisma zugeführt und dort in zwei senkrecht zueinander polarisierte Teillichtstrahlen aufgespalten, die jeweils einem Lichtdetektor zugeführt werden. Aus den beiden von den Lichtdetektoren gebildeten elektrischen Intensitätssignalen für die Lichtteilsignale wird von einer Auswerteelektronik ein intensitätsnormiertes Signal gebildet, das gleich dem Quotienten aus der Differenz und der Summe der beiden Intensitätssignale ist. Der zweite, für Schutzzwecke vorgesehene magnetooptische Stromwandler umfaßt ebenfalls eine Lichtquelle, einen zugeordneten Polarisator, eine Faser, die den Stromleiter in Form einer Meßwicklung umgibt und eine Auswerteelektronik. Im Gegensatz zum ersten, für Meßzwecke vorgesehenen Stromwandler ist der zweite Stromwandler vom Transmissionstyp, d.h. das in dem Polarisator linear polarisierte Licht der Lichtquelle wird in ein Ende der Meßwicklung eingekoppelt, durchläuft die Meßwicklung nur einmal, wird an dem anderen Ende der Meßwicklung wieder ausgekoppelt und der zugehörigen Auswerteelektronik zugeführt. Ferner weist die Meßwicklung des zweiten Stromwandlers zur Anpassung an den Überstrom-Meßbereich nur eine Meßwindung auf. Die optische Faser ist zur Unterdrückung ihrer intrinsischen zirkularen Doppelbrechung entlang einer Hälfte der Meßwindung in eine Drehrichtung und in der anderen Hälfte der Windung in entgegengesetzter Richtung um denselben Betrag tordiert (double-twisted fibre). Bei dieser bekannten Meßanordnung wird für jede der beiden Stromwandler eine eigene jeweils aus einer Lichtquelle und einem zugeordneten Polarisator aufgebaute Sendeeinheit zum Senden linear polarisierten Lichts benötigt.

Der Erfindung liegt die Aufgabe zugrunde, ein besonderes Verfahren und eine besondere Anordnung zum Messen von Strömen aus wenigstens zwei Meßbereichen in einem Stromleiter unter Ausnutzung des Faraday-Effekts anzugeben, bei denen nur eine Lichtquelle zum Senden von Meßlicht erforderlich ist.

Diese Aufgabe wird gemäß der Erfindung gelöst mit den Merkmalen des Anspruchs 1 bzw. des Anspruchs 4.

Der Erfindung liegt die Überlegung zugrunde, in dem induktiv erzeugten Magnetfeld eines Stromes in einem Stromleiter wenigstens zwei den Faraday-Effekt zeigende Faraday-Elemente anzuordnen und zum Messen eines Stromes aus einem ersten Strommeßbereich die Polarisationsdrehung von durch ein erstes der Faraday-Elemente gelaufenem, linear polarisiertem Meßlicht auszuwerten sowie zum Messen eines Stromes aus einem zweiten Strommeßbereich die Polarisationsdrehung von sowohl durch dieses erste Faraday-Element als auch durch wenigstens ein weiteres Faraday-Element gelaufenem, linear polarisiertem Meßlicht auszuwerten. Unter einem Meßbereich wird ein Bereich oder Intervall von Stromwerten für einen elektrischen Strom in dem Stromleiter als Definitionsbereich verstanden, über dem der sich der in Abhängigkeit vom elektrischen Strom einstellende Faraday-Drehwinkel eine eindeutige Funktion des Stromes ist.

Ausgehend von dieser Überlegung umfaßt das Meßverfahren zum Messen von Strömen aus wenigstens zwei Meßbereichen in einem Stromleiter mit Hilfe von wenigstens zwei, dem Stromleiter zugeordneten Faraday-Elementen folgende Verfahrensschritte:
a) als Maß für einen Strom aus einem ersten Meßbereich wird die Faraday-Drehung von nur durch das erste Faraday-Element gelaufenem, linear polarisiertem Meßlicht ausgewertet;
b) als Maß für einen Strom aus einem zweiten Meßbereich wird die Faraday-Drehung von durch jedes der beiden Faraday-Elemente wenigstens einmal gelaufenem, linear polarisiertem Meßlicht ausgewertet.

Bei der Meßanordnung sind ausgehend von der genannten Überlegung dem Stromleiter wenigstens zwei Faraday-Elemente zugeordnet, die über optische Verbindungsmittel optisch in Reihe geschaltet sind. Eine erste Auswerteeinheit wertet die Polarisationsdrehung von wenigstens einmal durch das erste Faraday-Element gelaufenem linear polarisierten Meßlicht als Maß für einen Strom aus dem ersten Meßbereich aus. Eine zweite Auswerteeinheit wertet dagegen die Faraday-Rotation von durch wenigstens zwei Faraday-Elemente jeweils wenigstens einmal gelaufenem linear polarisierten Meßlicht als Maß für einen Strom aus dem zweiten Meßbereich aus. Da die Polarisationsdrehung des durch zwei Faraday-Elemente gelaufenen Meßlichts bei gleichem Strom im Stromleiter größer ist als die Polarisationsdrehung des nur durch eines der zwei Faraday-Elemente gelaufenen Meßlichts, kann die zweite Auswerteeinheit kleinere Ströme messen als die erste Auswerteeinheit. Durch die genannten Maßnahmen genügt eine Lichtquelle zum Senden von Meßlicht, da das Meßlicht von den optischen Verbindungsmitteln in zwei Lichtanteile aufgeteilt werden kann, von denen ein Lichtanteil von der ersten Auswerteeinheit und der andere Lichtanteil von der zweiten Auswerteeinheit empfangen und ausgewertet wird. Außerdem ist ein kompakter Aufbau der Anordnung möglich, da die beiden Faraday-Elemente raumsparend nebeneinander angeordnet werden können.

Besondere Ausgestaltungen des Verfahrens und der Anordnung gemäß der Erfindung ergeben sich aus den jeweils abhängigen Ansprüchen.

In einer ersten Ausführungsform wird das erste Faraday-Element in einer Reflexionsanordnung betrieben. Von entsprechenden Mitteln wird in das erste Faraday-Element linear polarisiertes Meßlicht eingekoppelt und durchläuft das erste Faraday-Element ein erstes Mal. Die optischen Verbindungsmittel reflektieren nun einen ersten Anteil des Meßlichts in das erste Faraday-Element zurück und lassen einen zweiten Anteil des Meßlichts durch, der dem zweiten Faraday-Element zugeführt wird. Die Verbindungsmittel können dazu einen teildurchlässigen, im wesentlichen senkrecht zur Lichtausbreitungsrichtung angeordneten Spiegel enthalten. Der erste, zurückreflektierte Anteil des Meßlichts durchläuft das erste Faraday-Element ein zweites Mal in entgegengesetzter Richtung zum ersten Mal und wird dann der ersten Auswerteeinheit zugeführt.

In einer zweiten Ausführungsform wird das erste Faraday-Element in einer Transmissionsanordnung betrieben. Das linear polarisierte Meßlicht der Einkoppelmittel wird in dieser zweiten Ausführungsform nach Durchlaufen des ersten Faraday-Elements von den optischen Verbindungsmitteln in zwei Anteile aufgeteilt. Der erste Anteil des Meßlichts wird unmittelbar der ersten Auswerteeinheit zugeführt, ohne das erste Faraday-Element nochmals zu durchlaufen. Die Verbindungsmittel können dazu beispielsweise einen optischen Faserkoppler oder einen Strahlteiler enthalten. Der zweite Anteil des Meßlichts wird in das zweite Faraday-Element eingekoppelt. Dieser zweite Anteil des Meßlichts kann nun nach einmaligem Durchlaufen des zweiten Faraday-Elements entweder
A) direkt der zweiten Auswerteeinheit zugeführt werden oder
B) von lichtreflektierenden Mitteln in das zweite Faraday-Element zurückreflektiert und
   B1) nach nochmaligem Durchgang durch das zweite Faraday-Element der zweiten Auswerteeinheit zugeführt werden oder
   B2) nach nochmaligem Durchlaufen der Reihenschaltung beider Faraday-Elemente der zweiten Auswerteeinheit zugeführt werden
   oder
C) in zwei Lichtteile aufgespalten werden, von denen ein Teil wenigstens ein weiteres Faraday-Element wenigstens einmal durchläuft und von einer dritten Auswerteeinheit für einen Strom aus einem dritten Strommeßbereich ausgewertet wird und der andere Teil gegebenenfalls nach nochmaligem Durchlaufen wenigstens des zweiten Faraday-Elements der zweiten Auswerteeinheit zugeführt wird.
Bei der Ausführungsform zu C) weisen das zweite Faraday-Element und das weitere Faraday-Element vorzugsweise unterschiedliche Meßempfindlichkeiten auf.

Die Faraday-Elemente können insbesondere mit optischen Faserspulen oder massiven Ringkörpern um den Stromleiter gebildet sein.

Zur weiteren Erläuterung der Erfindung wird auf die Zeichnung Bezug genommen, in deren
- FIG. 1: eine Anordnung zum Messen von Strömen aus zwei Meßbereichen mit zwei jeweils im Transmissionsmodus betriebenen Faraday-Elementen,
- FIG. 2: eine Anordnung zum Messen von Strömen aus zwei Meßbereichen mit einem in Transmission betriebenen ersten Faraday-Element und einem im Reflexionsmodus betriebenen zweiten Faraday-Element,
- FIG. 3: eine Anordnung zum Messen von Strömen aus zwei Meßbereichen mit einem in Transmission betriebenen ersten Faraday-Element und einer im Reflexionsmodus betriebenen Reihenschaltung von zwei Faraday-Elementen,
- FIG. 4: eine Anordnung zum Messen von Strömen aus drei Meßbereichen mit einem in Transmission betriebenen ersten Faraday-Element und zwei Reihenschaltungen von jeweils einem weiteren Faraday-Element mit dem ersten Faraday-Element,
- FIG. 5: eine Anordnung zum Messen von Strömen aus drei Meßbereichen mit einer Reihenschaltung von drei Faraday-Elementen,
- FIG. 6: eine Anordnung zum Messen von Strömen aus zwei Meßbereichen mit zwei faseroptischen Faraday-Elementen und besonderen Auswerteeinheiten,
- FIG. 7: eine Anordnung zum Messen von Strömen aus zwei Meßbereichen mit einem in Reflexion betriebenen ersten Faraday-Element und einer in Transmission betriebenen Reihenschaltung aus diesem ersten und einem zweiten Faraday-Element,
- FIG. 8 und 9: zwei Anordnungen zum Messen von Strömen aus zwei Meßbereichen mit unterschiedlichen Auswerteeinheiten und
- FIG. 10: eine Anordnung zum Messen von Strömen aus drei Meßbereichen mit einem in Reflexion betriebenen ersten Faraday-Element und zwei Reihenschaltungen von jeweils einem weiteren Faraday-Element mit dem ersten Faraday-Element
schematisch veranschaulicht sind. Einander entsprechende Teile sind mit denselben Bezugszeichen versehen.

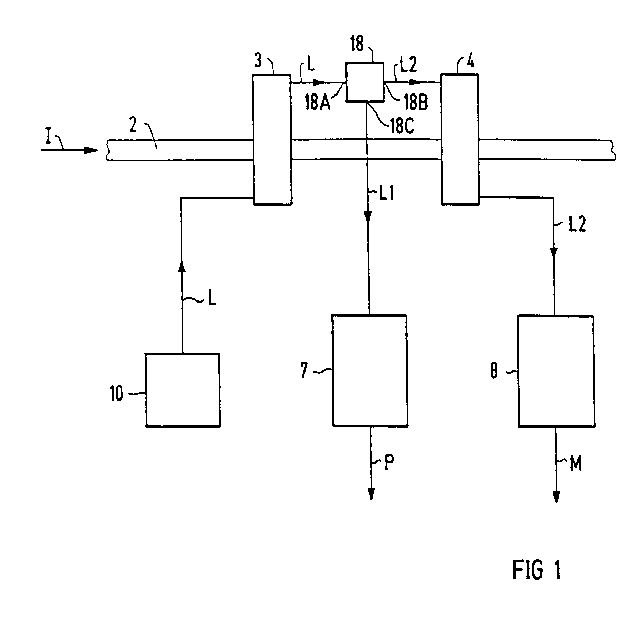

Die in FIG 1 gezeigte Ausführungsform der Anordnung zum Messen von Strömen aus zwei unterschiedlichen Meßbereichen umfaßt zwei Faraday-Elemente 3 und 4, die jeweils in räumlicher Nähe zu einem Stromleiter 2 angeordnet sind zum Messen eines elektrischen Stromes I in diesem Stromleiter 2 unter Ausnutzung des magnetooptischen Faraday-Effekts. Im allgemeinen umgeben wenigstens eines und vorzugsweise beide Faraday-Elemente 3 und 4 den Stromleiter 2, so daß durch das bzw. die Faraday-Elemente laufendes Licht den Stromleiter 2 entlang eines praktisch geschlossenen Lichtweges wenigstens einmal umläuft. Das erste Faraday-Element 3 und/oder das zweite Faraday-Element 4 können in einer Ausführungsform mit massiven, den Faraday-Effekt zeigenden Körpern, vorzugsweise aus Glas, gebildet sein. Es können ein oder auch mehrere Körper für jedes Faraday-Element 3 oder 4 vorgesehen sein. Vorzugsweise umgeben diese Körper den Stromleiter 2 in einem geschlossenen Lichtpfad. Ein einziger zusammenhängender Körper ist dann als im allgemeinen polygonaler Ringkörper ausgebildet. Solche massiven Körper, insbesondere ein Ringkörper, sind mechanisch robust und weisen praktisch keine zirkuläre Doppelbrechung auf. In einer anderen Ausführungsform sind das erste Faraday-Element 3 und/oder das zweite Faraday-Element 4 mit einer bzw. jeweils einer Lichtleitfaser gebildet, die vorzugsweise den Stromleiter 2 in Form einer Meßwicklung mit wenigstens einer Windung umgibt.

Das erste Faraday-Element 3 und das zweite Faraday-Element 4 sind über einen Dreitor-Koppler 18 als optische Verbindungsmittel optisch in Reihe geschaltet. Das erste Faraday-Element 3 ist dabei zwischen eine Sendeeinheit 10 zum Senden linear polarisierten Meßlichts L und das zweite Faraday-Element 4 geschaltet und wird deshalb zuerst vom linear polarisierten Meßlicht L der Sendeeinheit 10 durchlaufen. Als Sendeeinheit 10 können beispielsweise eine Laserdiode oder auch eine Lichtquelle (z.B. LED) mit nachgeschaltetem Polarisator vorgesehen sein. Der Dreitor-Koppler 18 zum optischen Koppeln der beiden Faraday-Elemente 3 und 4 ist derart ausgebildet, daß ein erster Teil L1 des von der Sendeeinheit 10 in das erste Faraday-Element 3 eingekoppelten und durch das erste Faraday-Element 3 gelaufenen Meßlichts L in die erste Auswerteeinheit 7 und ein zweiter Teil L2 des durch das erste Faraday-Element 3 gelaufenen Meßlichts L in das zweite Faraday-Element 4 eingekoppelt werden. Als Dreitor-Koppler 18 können ein strahlteilender, teildurchlässiger Spiegel, der unter einem Winkel von im allgemeinen 45° zur Strahlrichtung des auftreffenden Meßlichts L angeordnet ist, oder auch ein Y-Koppler, insbesondere ein Faserkoppler, vorgesehen sein.

Der zweite Teil L2 des Meßlichts L durchläuft das zweite Faraday-Element 4 nur einmal und wird dann unmittelbar in eine zweite Auswerteeinheit 8 eingekoppelt. Das zweite Faraday-Element 4 wird somit bezüglich des zweiten Teils L2 des Meßlichts L im Transmissionsmodus betrieben. Dazu ist das zweite Faraday-Element 4 mit einem zweiten Tor 18B des Dreitor-Kopplers 18 zum Einkoppeln des zweiten Teils L2 in das zweite Faraday-Element 4 und mit der zweiten Auswerteeinheit 8 zum Übertragen des durch das zweite Faraday-Element 4 transmittierten zweiten Teils L2 des Meßlichts L jeweils optisch verbunden. Ein erstes Tor 18A des Dreitor-Kopplers 18 ist mit dem ersten Faraday-Element 3 zum Übertragen des durch das erste Faraday-Element 3 gelaufenen Meßlichts L und ein drittes Tor 18C mit der ersten Auswerteeinheit 7 zum Übertragen des ersten Teils L1 des Meßlichts L optisch verbunden. Vorzugsweise sind zum Übertragen des ersten Teils L1 des Meßlichts L vom Dreitor-Koppler 18 zur ersten Auswerteeinheit 7 und des zweiten Teils L2 des Meßlichts L von dem zweiten Faraday-Element 4 zur zweiten Auswerteeinheit 8 jeweils ein Lichtwellenleiter, vorzugsweise eine polarisationserhaltende Lichtleitfaser, vorgesehen. Auch die optische Kopplung zwischen dem Dreitor-Koppler 18 und den Faraday-Elementen 3 und 4 kann über einen polarisationserhaltenden Lichtwellenleiter erfolgen. Schließlich wird auch das Meßlicht L der Sendeeinheit 10 zum ersten Faraday-Element 3 vorzugsweise mit einem polarisationserhaltenden Lichtwellenleiter übertragen.

Die erste Auswerteeinheit 7 wertet die Faraday-Drehung der Polarisationsebene des ersten Teils L1 des Meßlichts L für ein erstes Meßsignal P aus, das an einem Ausgang der ersten Auswerteeinheit 7 abgegriffen werden kann. Damit wird das erste Faraday-Element 3 im Transmissionsmodus betrieben. Die zweite Auswerteeinheit 8 wertet die Faraday-Drehung der Polarisationsebene des zweiten Teils L2 des Meßlichts L für ein zweites Meßsignal M aus, das an einem Ausgang der zweiten Auswerteeinheit 8 abgegriffen werden kann. Die gesamte Faraday-Drehung der Polarisationsebene des zweiten Teils L2 des Meßlichts L setzt sich dabei aus einem ersten, in dem ersten Faraday-Element 3 erfolgten ersten Faraday-Drehwinkelanteil und einem in dem zweiten Faraday-Element 4 bewirkten, zweiten Faraday-Drehwinkelanteil zusammen. Wenn die Faraday-Drehung in beiden Faraday-Elementen 3 und 4 in der gleichen Richtung erfolgte, entsprechend einem gleichen Umlaufsinn des transmittierten Lichts in erstem Faraday-Element 3 und zweitem Faraday-Element 4 relativ zur Stromrichtung im Stromleiter 2, dann ist der gesamte Drehwinkel gleich der Summe der beiden einzelnen Drehwinkel. Bei entgegengesetzter Drehrichtung entspricht der resultierende Drehwinkel dagegen der Differenz der beiden einzelnen Drehwinkel.

Die optische Reihenschaltung aus den beiden Faraday-Elementen 3 und 4 wird in der Ausführungsform gemäß FIG. 1 im Transmissionsmodus bezüglich des zweiten Teils L2 des Meßlichts L betrieben.

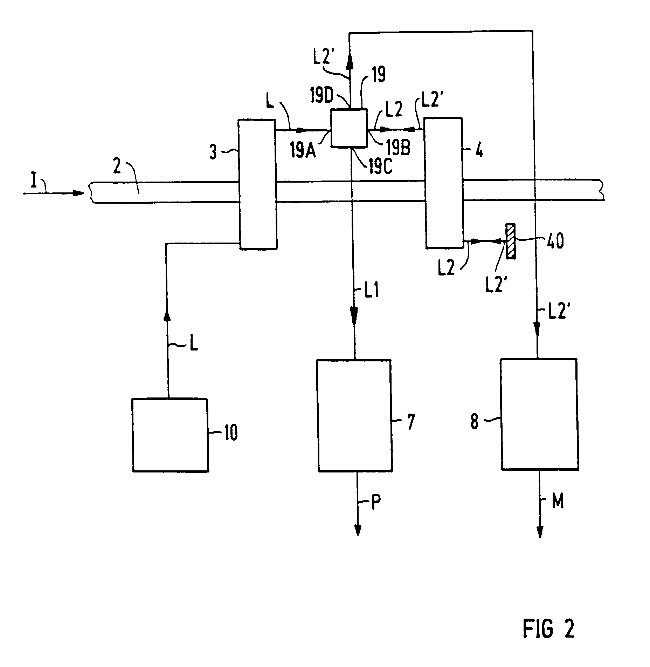

Die FIG. 2 zeigt eine weitere Ausführungsform der Meßanordnung. Das erste Faraday-Element 3 und das zweite Faraday-Element 4 sind über einen optischen Viertor-Koppler 19 mit vier Toren 19A bis 19D als optische Verbindungsmittel optisch in Reihe geschaltet. Die zweite Auswerteeinheit 8 ist mit dem Tor 19D des Viertor-Kopplers 19 optisch verbunden. Dem zweiten Faraday-Element 4 sind lichtreflektierende Mittel 40, beispielsweise ein Spiegel, zugeordnet, die den zweiten Teil L2 des Meßlichts L nach erstmaligem Durchlaufen des zweiten Faraday-Elements 4 in das zweite Faraday-Element 4 zurückreflektieren. Der zurückreflektierte zweite Teil des Meßlichts L ist mit L2' bezeichnet. Dieser zurückreflektierte zweite Teil L2' durchläuft das zweite Faraday-Element 4 in umgekehrter Richtung ein zweites Mal und wird über den Viertor-Koppler 19 dann der zweiten Auswerteeinheit 8 zugeführt. Das mit dem zweiten Faraday-Element 4 verbundene Tor 19B und das mit der zweiten Auswerteeinheit 8 verbundene Tor 19D des Viertor-Kopplers 19 sind dazu optisch miteinander gekoppelt. Ebenfalls optisch miteinander gekoppelt sind das mit dem ersten Faraday-Element 3 verbundene Tor 19A und das mit der ersten Auswerteeinheit 7 verbundene Tor 19C des Viertor-Kopplers 19. Als Viertor-Koppler 19 kann beispielsweise ein Strahlteiler mit einem schräg zur Lichtausbreitungsrichtung angeordneten teildurchlässigen Spiegel oder ein faseroptischer Koppler vorgesehen sein. Das zweite Faraday-Element 4 wird in dieser Ausführungsform gemäß FIG. 2 somit im Reflexionsmodus betrieben. Der von der zweiten Auswerteeinheit 8 ausgewertete Lichtteil L2' weist eine Faraday-Rotation seiner Polarisationsebene auf, die sich aus der Faraday-Drehung bei einem Durchlauf des ersten Faraday-Elements 3 und der doppelten Faraday-Drehung bei einem Durchlauf des zweiten Faraday-Element 4 zusammensetzt.

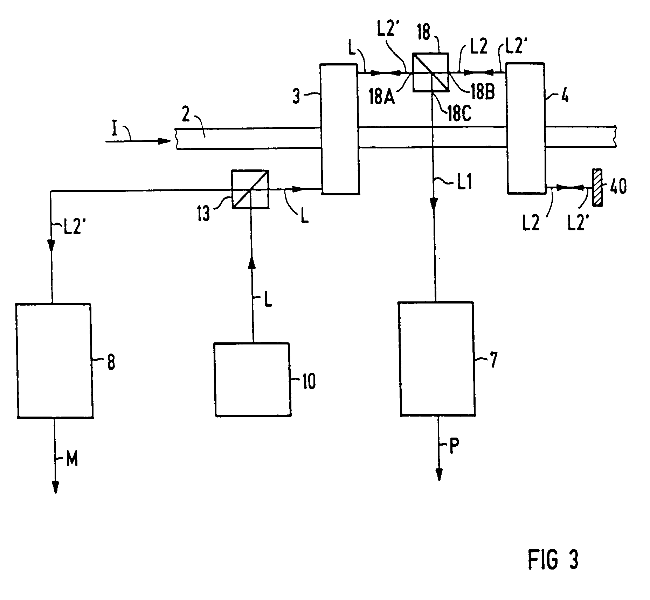

Die FIG. 3 zeigt eine weitere Ausführungsform der Meßanordnung mit zwei Faraday-Elementen 3 und 4. Die beiden Faraday-Elemente 3 und 4 sind über einen Dreitor-Koppler 18 miteinander optisch gekoppelt. Dem zweiten Faraday-Element 4 sind wie in FIG. 2 lichtreflektierende Mittel 40 zugeordnet, die den einmal durch das zweite Faraday-Element 4 transmittierten zweiten Teil L2 des Meßlichts L in das zweite Faraday-Element 4 wieder zurückreflektieren. Der zurückreflektierte zweite Teil L2' des Meßlichts L durchläuft das zweite Faraday-Element 4 ein zweites Mal in umgekehrtem Umlaufsinn, wird über das Tor 18B des Dreitor-Kopplers 18 und das Tor 18A dem ersten Faraday-Element 3 zugeführt. Anschließend durchläuft dieser zweite Teil L2' des Meßlichts L das erste Faraday-Element 3 ein zweites Mal in umgekehrter Richtung und wird dann der zweiten Auswerteeinheit 8 vorzugsweise über einen weiteren optischen Koppler 13 zugeleitet. Der optische Koppler 13 verbindet das erste Faraday-Element 3 sowohl mit der Sendeeinheit 10 als auch mit der zweiten Auswerteeinheit 8. Das von der Sendeeinheit 10 gesendete, linear polarisierte Meßlicht L wird über den Koppler 13 in das erste Faraday-Element 3 eingekoppelt. Als Koppler 13 kann ein Faserkoppler oder auch ein mit einem teildurchlässigen Spiegel gebildeter Strahlteiler vorgesehen sein.

Die Sendeeinheit 10 kann eine linear polarisierte Lichtquelle wie beispielsweise eine Laserdiode oder eine Lichtquelle mit nachgeschaltetem Polarisator sein oder auch in einer nicht dargestellten Ausführungsform aus einer Lichtquelle und unmittelbar vor dem ersten Faraday-Element 3 angeordneten polarisierenden Mitteln wie beispielsweise einem Polarisationsfilter zum linearen Polarisieren des Lichts der Lichtquelle aufgebaut sein. In der letztgenannten Ausführungsform der Sendeeinheit 10 ist der optische Koppler 13 optisch zwischen die Lichtquelle und die polarisierenden Mittel geschaltet.

In allen Ausführungsformen werden die Meßempfindlichkeiten der Faraday-Elemente 3 und 4 vorzugsweise so gewählt, daß das Meßsignal M ein eindeutiges Maß für einen Strom aus einem ersten, vorgegebenen Meßbereich und das andere Meßsignal P ein eindeutiges Maß für einen Strom aus einem zweiten, vorgegebenen Meßbereich ist. Zur Einstellung unterschiedlicher Meßempfindlichkeiten der beiden Faraday-Elemente 3 und 4 können beispielsweise Materialien mit unterschiedlichen Verdet-Konstanten für die beiden Faraday-Elemente 3 bzw. 4 verwendet werden oder auch Faraday-Elemente 3 und 4 mit unterschiedlichen Lichtweglängen entlang des vom Strom I erzeugten Magnetfeldes verwendet werden. In einer besonders vorteilhaften Ausführungsform wird der Meßbereich des im Transmissionsmodus betriebenen, ersten Faraday-Elements 3 einem vorgegebenen Überstrom-Meßbereich für Schutzzwecke angepaßt, der typischerweise im Bereich zwischen 10 kA und wenigstens 100 kA liegt. Die von in diesem ÜberstromMeßbereich liegenden Überströmen I erzeugten, hinreichend großen Faraday-Drehwinkel werden dann von der ersten Auswerteeinheit 7 für ein Meßsignal P als Schutzsignal ausgewertet. Der aus den Einzelmeßbereichen der beiden Faraday-Elemente 3 und 4 resultierende Gesamtmeßbereich der Reihenschaltung der beiden Faraday-Elemente 3 und 4 wird einem vorgegebenen Nennstrom-Meßbereich angepaßt, wobei die Anzahl der Durchläufe des zweiten Teils L2 des Meßlichts L durch jedes einzelne Faraday-Element 3 und 4 berücksichtigt wird. Der Nennstrom-Meßbereich liegt üblicherweise etwa um einen Faktor 10 bis 30 unterhalb des Überstrom-Meßbereichs. Unter dem Gesamtmeßbereich wird ein Strommeßbereich verstanden, über dem der Gesamtdrehwinkel des durch beide Faraday-Elemente 3 und 4 wenigstens einmal transmittierten zweiten Teils L2 des Meßlichts L eine eindeutige Funktion des Stromes I ist. Der Gesamtdrehwinkel wird von der zweiten Auswerteeinheit 8 für das zweite Meßsignal M als Maß für einen im Nennstrom-Meßbereich liegenden Strom I ausgewertet. Der Faraday-Drehwinkel im ersten Faraday-Element 3 ist bei Nennströmen I wegen der vegleichsweise geringen Meßempfindlichkeit des ersten Faraday-Elements 3 im allgemeinen deutlich kleiner als der Faraday-Drehwinkel im zweites Faraday-Element 4.

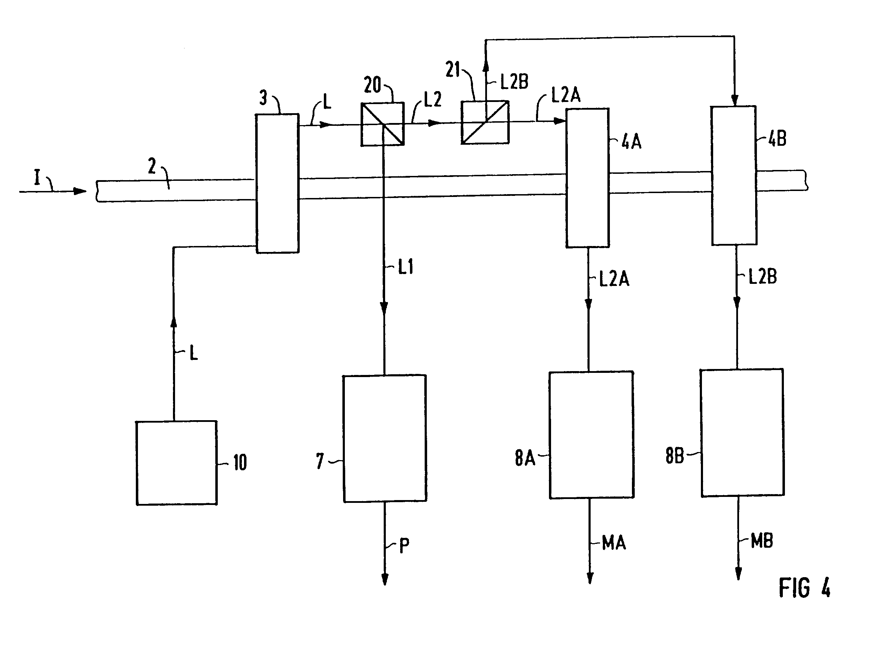

In der Ausführungsform der Meßanordnung gemäß FIG. 4 sind neben dem ersten Faraday-Element 3 und der zugeordneten ersten Auswerteeinheit 7 zwei weitere Faraday-Elemente 4A und 4B vorgesehen, die jeweils mit dem ersten Faraday-Element 3 optisch in Reihe geschaltet sind und denen jeweils eine Auswerteeinheit 8A bzw. 8B zugeordnet ist. Die zweite Auswerteeinheit 8A wertet einen durch die Reihenschaltung von dem ersten Faraday-Element 3 und dem zweiten Faraday-Element 4A transmittierten Lichtanteil L2A des Meßlichts L für ein Meßsignal MA aus, und die dritte Auswerteeinheit 8B wertet einen durch die Reihenschaltung des ersten Faraday-Elements 3 mit dem dritten Faraday-Element 4B transmittierten Lichtanteil L2B für ein weiteres Meßsignal MB aus. Als optische Verbindungsmittel zum Verbinden von erstem Faraday-Element 3 mit den Faraday-Elementen 4A und 4B sind zwei optisch hintereinander geschaltete Strahlteiler 20 und 21 vorgesehen. Der erste Strahlteiler 20 teilt das aus dem ersten Faraday-Element 3 ausgekoppelte Meßlicht L in einen ersten Teil L1 und einen zweiten Teil L2. Der erste Teil L1 des Meßlichts L wird der ersten Auswerteeinheit 7 zugeführt, und der zweite Teil L2 des Meßlichts L wird zum zweiten Strahlteiler 21 weitergeleitet. Im zweiten Strahlteiler 21 wird dieser zweite Teil L2 in die zwei Lichtanteile L2A und L2B geteilt. Der erste Lichtanteil L2A wird dann in das zweite Faraday-Element 4A eingekoppelt und nach Durchlaufen dieses Faraday-Elements 4A der ersten weiteren Auswerteeinheit 8A zugeführt. Der zweite Lichtanteil L2B wird hingegen in das dritte Faraday-Element 4B eingekoppelt und nach Durchlaufen dieses dritten Faraday-Elements 4B der zweiten weiteren Auswerteeinheit 8B zum Auswerten zugeführt. Die optischen Verbindungsmittel teilen demnach das Meßlicht L nach Durchlaufen des ersten Faraday-Elements 3 in drei Teile L1, L2A und L2B und koppeln den ersten Teil L1 in die erste Auswerteeinheit 7, den zweiten Teil L2A in das zweite Faraday-Element 4A und den dritten Teil L2B in das dritte Faraday-Element 4B. Optische Verbindungsmittel mit dieser Funktion können beispielsweise auch mit optischen Y-Kopplern oder Mehrfachspleißen ausgebildet sein. Die unterschiedlichen Faraday-Drehungen jedes dieser Lichtteile L1, L2A und L2B werden jeweils von der zugeordneten Auswerteeinheit 7,8A bzw. 8B ausgewertet zum Ableiten des zugehörigen Meßsignals P, MA bzw. MB für einen Strom aus einem zugehörigen Meßbereich. Durch entsprechende Wahl der Meßempfindlichkeiten der beiden weiteren Faraday-Elemente 4A und 4B können in dieser Ausführungsform Ströme aus drei verschiedenen Meßbereichen gemessen werden.

Es können auch mehr als zwei weitere Faraday-Elemente vorgesehen sein, die jeweils mit dem ersten Faraday-Element 3 in Reihe geschaltet sind.

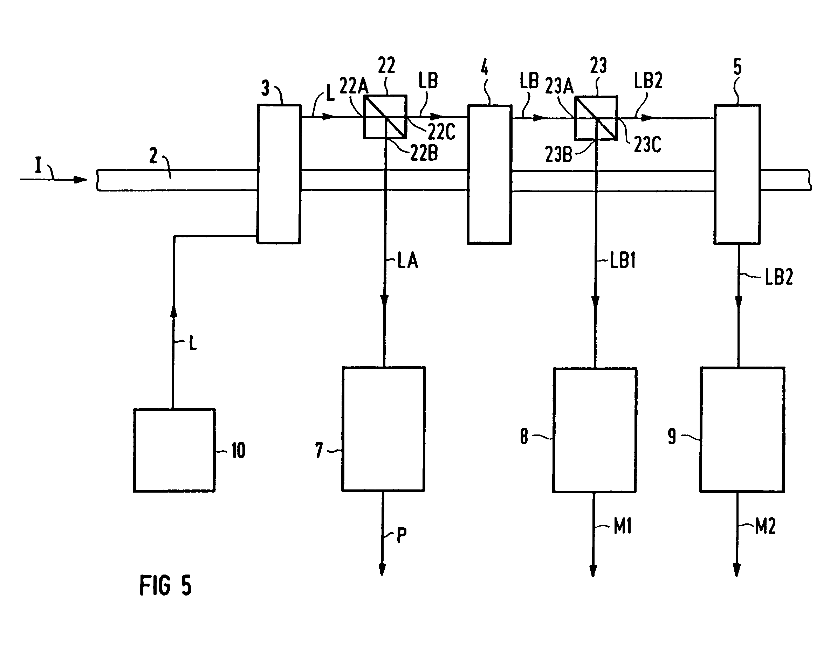

FIG. 5 zeigt eine Ausführungsform der Anordnung mit drei Faraday-Elementen 3, 4 und 5 zum Messen von elektrischen Strömen I aus drei Meßbereichen. Die drei Faraday-Elemente 3, 4 und 5 sind optisch in Reihe geschaltet. Das erste Faraday-Element 3 ist über einen Dreitor-Koppler 22, beispielsweise einen Strahlteiler, mit dem zweiten Faraday-Element 4 und mit der ersten Auswerteeinheit 7 optisch gekoppelt. Das zweite Faraday-Element 4 ist über einen weiteren Dreitor-Koppler 23 mit dem dritten Faraday-Element 5 und einer zweiten Auswerteeinheit 8 optisch gekoppelt. Linear polarisiertes Meßlicht L der Sendeeinheit 10 durchläuft das erste Faraday-Element 3 und wird dann einem Tor 22A des Dreitor-Kopplers 22 zugeführt. Der Dreitor-Koppler 22 teilt das Meßlicht L in einen ersten Lichtanteil LA, der über ein zweites Tor 22B des Dreitor-Kopplers 22 der ersten Auswerteeinheit 7 zugeführt wird, und einen zweiten Lichtanteil LB, der über ein drittes Tor 22C des Dreitor-Kopplers 22 dem zweiten Faraday-Element 4 zugeführt wird. Nach Durchlaufen auch des zweiten Faraday-Elements 4 wird der zweite Lichtanteil LB einem ersten Tor 23A eines weiteren Dreitor-Kopplers 23 zugeführt und vom weiteren Dreitor-Koppler 23 in einen Lichtanteil LB1 und einen Lichtanteil LB2 aufgeteilt. Der Lichtanteil LB1 wird von einem Tor 23B des Dreitor-Kopplers 23 zur zweiten Auswerteeinheit 8 gekoppelt. Der Lichtanteil LB2 wird an einem weiteren Tor 23C des Dreitor-Kopplers 23 ausgekoppelt, durchläuft das dritte Faraday-Element 5 und wird dann der dritten Auswerteeinheit 9 zugeführt. Die erste Auswerteeinheit 7 leitet aus dem Lichtanteil LA des Meßlichts L nach dessen Transmission durch das erste Faraday-Element 3 ein Meßsignal P für einen Strom I aus einem ersten Meßbereich ab. Die zweite Auswerteeinheit 8 leitet aus dem durch die Reihenschaltung aus erstem Faraday-Element 3 und zweitem Faraday-Element 4 gelaufenen Meßlichtanteil LB1 ein Meßsignal M1 für einen Strom I aus einem zweiten Meßbereich ab. Die dritte Auswerteeinheit 9 schließlich leitet aus dem durch die Reihenschaltung aller drei Faraday-Elemente 3, 4 und 5 gelaufenen Meßlichtanteil LB2 ein Meßsignal M2 her als Maß für einen Strom I aus einem dritten Meßbereich. Die drei Strommeßbereiche können insbesondere durch die Wahl der Meßempfindlichkeiten der Faraday-Elemente 3, 4 und 5 eingestellt werden.

Für die Auswertung der Faraday-Drehwinkel in der ersten Auswerteeinheit 7 sowie in den weiteren Auswerteeinheiten 8, 8A, 8B oder 9 können prinzipiell alle analogen und digitalen Auswerteverfahren zum Erfassen des Polarisationszustandes von linear polarisiertem Licht verwendet werden.

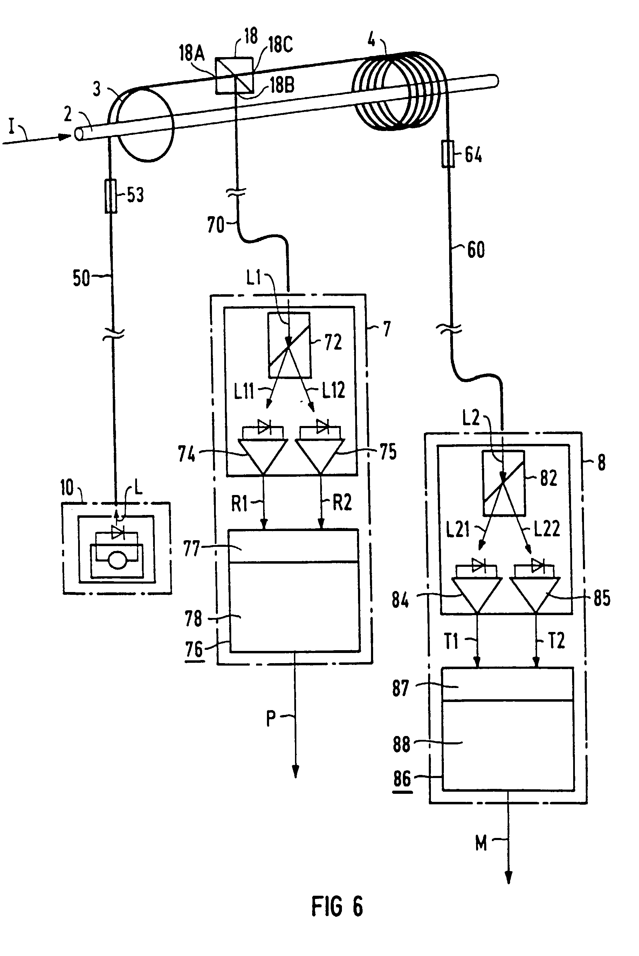

Die FIG. 6 zeigt eine Ausführungsform mit zwei jeweils als Faserspule ausgebildeten, in Reihe geschalteten Faraday-Elementen und mit vorteilhaften Auswerteeinheiten. Sowohl für das erste Faraday-Element 3 als auch für das zweite Faraday-Element 4 ist jeweils eine optische Faser vorgesehen, die den Stromleiter 2 in Form einer Meßwicklung umgibt. Vorzugsweise sind getemperte optische Fasern (annealed fibres) vorgesehen, die sich durch niedrige lineare Doppelbrechung und praktisch vernachlässigbare zirkuläre Doppelbrechung auszeichnen. Zur Anpassung der Strommeßbereiche kann in dieser Ausführungsform neben der Wahl unterschiedlicher Materialien für die beiden Faraday-Elemente 3 und 4 auch die Zahl der Windungen der Meßwicklungen variiert werden. Die Meßwicklung des zweites Faraday-Elements 4 weist dabei vorzugsweise mehr Windungen auf als die Wicklung des ersten Faraday-Elements 3. Damit liegt der Meßbereich des zweites Faraday-Elements 4 für sich betrachtet bei vergleichbarer Faraday-Drehung der Fasermaterialien beider Faraday-Elemente 3 und 4 bei kleineren Strömen I als der Meßbereich des ersten Faraday-Elements 3 für sich betrachtet. In der dargestellten Ausführungsform wird der Gesamtmeßbereich für die Reihenschaltung beider Faraday-Elemente 3 und 4 vorzugweise über die Summe der Windungen der beiden Meßwicklungen des ersten Faraday-Elements 3 und des zweiten Faraday-Elements 4 bei gleichem Umlaufsinn der Windungen angepaßt. Die Sendeeinheit 10 erzeugt linear polarisiertes Meßlicht L, das über einen polarisationserhaltenden Lichtwellenleiter 50 als Übertragungsstrecke in das erste Faraday-Element 3 eingekoppelt wird. Als polarisationserhaltender Lichtwellenleiter 50 kann eine niedrigdoppelbrechende Lichtfaser (LoBi-Fibre) vorgesehen sein. Ein Spleiß 53 verbindet vorzugsweise den Lichtwellenleiter 50 mit der Meßwicklung des ersten Faraday-Elements 3. Das zweite Faraday-Element 4 und die zweite Auswerteinheit 8 sind vorzugsweise ebenfalls über einen polarisationserhaltenden Lichtwellenleiter 60 optisch verbunden. Dieser Lichtwellenleiter 60 kann auch über einen Spleiß 64 mit der Meßwicklung des zweiten Faraday-Elements 4 verbunden sein und/oder als LoBi-Fibre ausgebildet sein. Die Reihenschaltung der beiden Faraday-Elemente 3 und 4 erfolgt vorzugsweise mit einem strahlteilenden Spleiß als Dreitor-Koppler 18 und wird im Transmissionsmodus wie in der Ausführungsform gemäß FIG. 1 betrieben. Die Faraday-Elemente 3 und 4 können aber auch wie in den Ausführungsformen gemäß FIG. 2 oder 3 betrieben werden.

In FIG. 6 sind ferner vorteilhafte Ausführungsformen der beiden Auswerteeinheiten 7 und 8 dargestellt. In der ersten Auswerteeinheit 7 sind mit einem Tor 18B des Dreitor-Kopplers 18 vorzugsweise über einen polarisationserhaltenden Lichtleiter 70 optisch gekoppelte Mittel 72 zum Aufteilen des ersten Teils L1 des durch das erste Faraday-Element 3 gelaufenen Meßlichts L in zwei linear polarisierte Teillichtsignale L11 und L12 mit unterschiedlichen Polarisationsebenen vorgesehen. Ferner enthält dieses Auswerteeinheit 7 photoelektrische Wandler 74 und 75 zum Umwandeln der Teillichtsignale L11 bzw. L12 in jeweils ein elektrisches Signal R1 bzw. R2 als Maß für die Intensität des jeweiligen Teillichtsignals L11 bzw. L12 sowie elektronische Mittel 76 zum Ableiten des Meßsignals P aus diesen beiden elektrischen Signalen R1 und R2. Als Mittel 72 zum Aufteilen des Meßlichtanteils L1 in die zwei Teillichtsignale L11 und L12 können ein polarisierender Strahlteiler, vorzugsweise ein Wollaston-Prisma, oder auch ein Strahlteiler und zwei optisch nachgeschaltete, um einen vorgegebenen Winkel gekreuzte Analysatoren vorgesehen sein. Die Teillichtsignale L11 und L12 können in einer Freistrahlanordnung oder auch über Lichtleitfasern zu den Wandlern 74 und 75 übertragen werden. Die Ausgänge der photoelektrischen Wandler 74 und 75 sind jeweils mit einem Eingang der elektronischen Mittel 76 elektrisch verbunden. Die elektronischen Mittel 76 enthalten in einer bevorzugten Ausführungsform einen Analog-/Digital-Wandler 77 zum Digitalisieren der beiden Signale R1 und R2 und eine nachgeschaltete digitale Recheneinheit 78 zum Berechnen des Meßsignals P als Maß für einen Strom aus einem ersten Meßbereich im Stromleiter 2. Vorzugsweise wird in der Recheneinheit 78 zunächst ein Quotientensignal (R1-R2)/R1+R2) aus der Differenz R1-R2 und der Summe R1+R2 der beiden elektrischen Signale R1 und R2 berechnet. Dieses Quotientensignal ist von Intensitätsschwankungen der Sendeeinheit 10 oder in den Übertragungsstrecken weitgehend befreit und proportional zum cos(2α) mit dem Faraday-Drehwinkel a. Ein Meßsignal P als direktes Maß für den Strom I im Stromleiter 2 ergibt sich dann aus der Beziehung P = α/(Nₛ·Vₛ), wobei Nₛ die Anzahl der Windungen des ersten Faraday-Elements 3 und Vₛ die Verdet-Konstante des Materials des ersten Faraday-Elements 3 sind. Typischerweise ist Nₛ zwischen 1 und 3 für eine Überstrommessung.

Die zweite Auswerteeinheit 8 ist analog zur ersten Auswerteeinheit 7 aufgebaut. Es sind mit dem zweiten Faraday-Element 4 über einen polarisationserhaltenden Lichtwellenleiter 60 optisch verbundene Mittel 82 zum Aufteilen des linear polarisierten, durch das zweite Faraday-Element 4 transmittierten Lichtanteile L2 in zwei linear polarisierte Teillichtsignale L21 und L22 mit unterschiedlichen Polarisationsebenen vorgesehen, vorzugsweise ein Wollaston-Prisma. Der Lichtwellenleiter 60 ist mit der Faser des zweiten Faraday-Elements 4 über einen Spleiß 64 verbunden. Als polarisationserhaltender Lichtwellenleiter 60 kann insbesondere eine optische Faser mit hoher linearer Doppelbrechung (HiBi-Faser) vorgesehen werden, deren Eigenachsen der linearen Doppelbrechung auf die Eigenachsen des Wollaston-Prismas 82 justiert sind. Ferner enthält die zweite Auswerteeinheit photoelektrische Wandler 84 und 85 zum Umwandeln dieser Teillichtsignale L21 und L22 in jeweils ein elektrisches Signal T1 bzw. T2 als Maß für die Intensität des jeweiligen Teillichtsignals L21 bzw. L22 und elektronische Mittel 86 zum Ableiten des Meßsignals M aus den beiden elektrischen Signale T1 und T2. Die den Lichtintensitäten der Teillichtsignale L21 und L22 entsprechenden elektrischen Signale T1 und T2 an den Ausgängen der Wandler 84 und 84 werden wieder einem Analog-/Digital-Wandler 87 und einer nachgeschalteten digitalen Recheneinheit 88 von elektronischen Mitteln 86 zugeführt. Vorzugsweise wird in der Recheneinheit 88 ebenfalls zunächst ein intensitätsnormiertes Quotientensicnal (T1-T2)/(T1+T2) aus der Differenz T1-T2 und der Summe T1+T2 der beiden elektrischen Signale T1 und T2 hergeleitet. Dieses Quotientensignal ist proportional zu cos(2β) mit dem Faraday-Gesamtdrehwinkel β des transmittierten polarisierten Lichtanteils LT. Das einem Strom I in dem Stromleiter 2 vorzugsweise aus einem Nennstrombereich entsprechende Meßsignal M ergibt sich dann aus der Beziehung M = β/(Nₛ·Vₛ+N_{M}·V_{M}) mit der Windungszahl N_{M} und der Verdetzahl N_{M} des zweiten Faraday-Elements 4 wird im allgemeinen zwischen 10 und 50 gewählt.

Zusätzlich kann wegen der insbesondere für Nennströme geforderten hohen Meßgenauigkeit ein Temperaturkompensationsverfahren durchgeführt werden.

Als Wertebereich für den Faraday-Drehwinkel α als Funktion eines Stroms im ersten Meßbereich (Überstrom) und den Faraday-Gesamtdrehwinkel β als Funktion eines Stroms im zweiten Meßbereich (Nennstrom) wird in der Regel jeweils das Intervall [-π/4; +π/4] gewählt. Die Drehwinkel α und β sind dann eindeutige Funktionen, die einen Wert aus dem Meßbereich, einen Strom, auf einen Wert aus dem Wertebereich, einen Drehwinkel, abbilden.

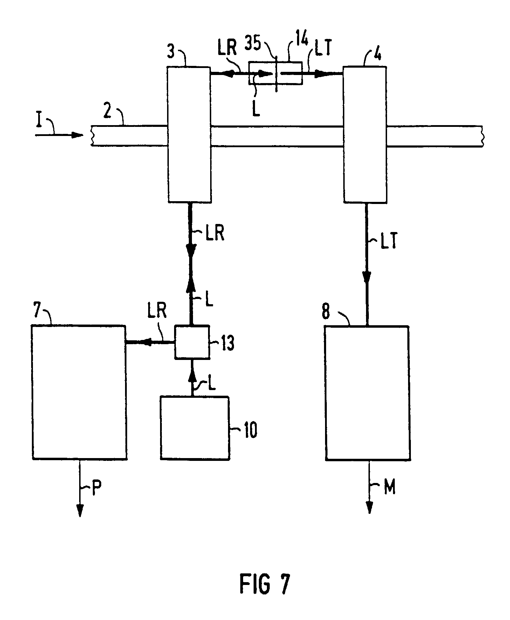

In der Ausführungsform gemäß FIG. 7 sind ein erstes Faraday-Element 3 und ein zweites Faraday-Element 4 im Magnetfeld eines elektrischen Stromes I in einem Stromleiter 2 angeordnet und über optische Verbindungsmittel 14 optisch in Reihe geschaltet. Die Reihenschaltung aus erstem Faraday-Element 3 und zweitem Faraday-Element 4 ist optisch zwischen die Sendeeinheit 10 und die zweite Auswerteeinheit 8 geschaltet. Das erste Faraday-Element 3 ist dabei zwischen die Sendeeinheit 10 und das zweite Faraday-Element 4 geschaltet und wird deshalb zuerst vom linear polarisierten Meßlicht L der Sendeeinheit 10 durchlaufen. Ein optischer Koppler 13 verbindet das erste Faraday-Element 3 sowohl mit einer Sendeeinheit 10 zum Sendenvon linear polarisiertem Meßlicht L als auch mit einer ersten Auswerteeinheit 7. Dieser Koppler 13 kann ein Y-Faserkoppler oder auch ein mit einem teildurchlässigen Spiegel gebildeter Strahlteiler sein.

Die optischen Verbindungsmittel 14 zum optischen Koppeln der beiden Faraday-Elemente 3 und 4 sind nun derart ausgebildet, daß ein Teil LR des durch das erste Faraday-Element 3 gelaufenen Meßlichts L in das erste Faraday-Element 3 zurückreflektiert wird und ein anderer Teil LT durchgelassen und in das zweite Faraday-Element 4 eingekoppelt wird. Dazu enthalten die optischen Verbindungsmittel 14 vorzugsweise einen teildurchlässigen Spiegel 35, der im wesentlichen senkrecht zur Strahlrichtung des auftreffenden Meßlichts L angeordnet ist. Es können allerdings auch ein Strahlteiler mit einem unter einem Winkel, beispielsweise 45°, zur Strahlrichtung des einfallenden Meßlichts L gerichteten teildurchlässigen Spiegel und ein im Strahlengang des an diesem teildurchlässigen Spiegel reflektierten Meßlichtanteils LR angeordneter weiterer Spiegel zum Zurückreflektieren dieses Meßlichtanteils LR zum teildurchlässigen Spiegel vorgesehen sein. Der von den optischen Verbindungsmitteln 14 zurückreflektierte Lichtanteil LR durchläuft das erste Faraday-Element 3 in umgekehrter Richtung ein zweites Mal und wird über den optischen Koppler 13 der ersten Auswerteeinheit 7 zugeführt. Das erste Faraday-Element 3 wird somit im Reflexionsmodus betrieben. Das hat den Vorteil, daß wegen der Nicht-Reziprokitat des Faraday-Effekts das Meßlicht LR eine Faraday-Drehung erfährt, die doppelt so groß ist wie bei nur einmaligem Durchlaufen des Faraday-Elements 3, die Effekte einer möglichen zirkularen Doppelbrechung im ersten Faraday-Elements 3 hingegen sich wegen ihrer reziproken Eigenschaft gerade herausheben. Die Auswerteeinheit 7 leitet aus dem zweimal durch das erste Faraday-Element 3 gelaufenen Meßlichtanteil LR ein erstes Meßsignal P ab. Der von den optischen Verbindungsmitteln 14 durchgelassene Anteil LT des Meßlichts L durchläuft dagegen nach dem ersten Faraday-Element 3 auch das zweite Faraday-Element 4 und wird nach dem Durchlaufen des zweiten Faraday-Element 4 der zweiten Auswerteeinheit 8 zugeführt. Die Reihenschaltung aus erstem Faraday-Element 3 und zweitem Faraday-Element 4 wird somit für den transmittierten Teil LT des Meßlichts L im Transmissionsmodus betrieben. Der an der Auswerteeinheit 8 ankommende linear polarisierte Lichtanteil LT weist eine Polarisationsebene auf, die sowohl in dem ersten Faraday-Element 3 um einen ersten Faraday-Drehwinkel als auch in dem zweiten Faraday-Element 4 um einen zweiten Faraday-Drehwinkel gedreht wurde. Wenn die Faraday-Drehung in beiden Faraday-Elementen 3 und 4 in der gleichen Richtung erfolgte, entsprechend einem gleichen Umlaufsinn des transmittierten Lichts in erstem Faraday-Element 3 und zweitem Faraday-Element 4, dann ist der gesamte Drehwinkel gleich der Summe der beiden einzelnen Drehwinkel. Bei entgegengesetzter Drehrichtung entspricht der resultierende Drehwinkel dagegen der Differenz der beiden einzelnen Drehwinkel. In der Auswerteeinheit 8 wird der resultierende Gesamtdrehwinkel für ein zweites Meßsignal M ausgewertet. Die Meßempfindlichkeiten der beiden Faraday-Elemente 3 und 4 sind nun so eingestellt, daß das Meßsignal M ein eindeutiges Maß für Ströme aus einem ersten Meßbereich, insbesondere Nennströme, und das andere Meßsignal P ein eindeutiges Maß für Ströme aus einem zweiten Meßbereich, insbesondere Überströme, ist.

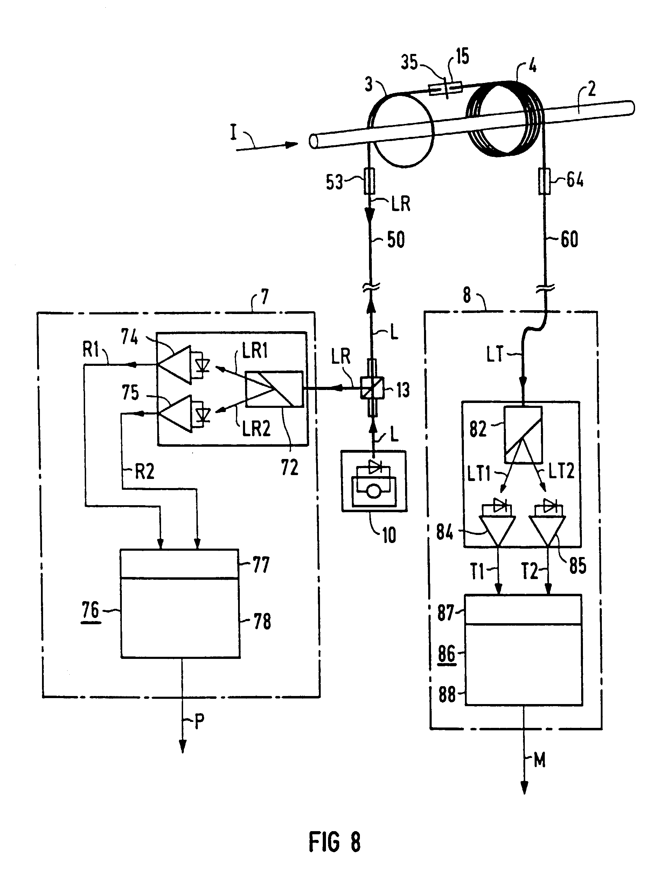

Die FIG.8 zeigt eine vorteilhafte Ausführungsform der Meßanordnung. Sowohl für das erste Faraday-Element 3 als auch für das zweite Faraday-Element 4 sind wie in FIG. 6 jeweils ein optischer Lichtwellenleiter, vorzugsweise eine optische Faser, vorgesehen, die den Stromleiter 2 in Form einer Meßwicklung umgibt. Vorzugsweise sind getemperte optische Fasern (annealed fibres) vorgesehen, die sich durch niedrige intrinsische lineare Doppelbrechung und praktisch vernachlässigbare intrinsische zirkuläre Doppelbrechung auszeichnen. Die beiden Faraday-Elemente 3 und 4 sind über optische Verbindungsmittel 15 in Reihe geschaltet. Die optischen Verbindungsmittel 15 sind teilreflektierend und vorzugsweise mit einem halbdurchlässigen Spiegel 35 am Ende einer der beiden Fasern des ersten Faraday-Elements 3 bzw. des zweiten Faraday-Elements 4, der durch Sputtern oder chemische Ablagerung auf das Faserende aufgebracht sein kann, und mechanischen Verbindungsmitteln zum Verbinden des mit dem Spiegel versehenen Faserendes mit dem benachbarten Faserende des anderen Faraday-Elements ausgebildet. Die mechanischen Verbindungsmittel können eine lösbare Steckverbindung oder auch ein unlösbarer Spleiß, beispielsweise ein Kapillarröhrchen der Firma Nippon Electric Glass, sein. Die Sendeeinheit 10 erzeugt linear polarisiertes Meßlicht L, das über den Koppler 13 und einen polarisationserhaltenden Lichtwellenleiter 50 als Übertragungsstrecke zwischen Koppler 13 und Faraday-Element 3 in das erste Faraday-Element 3 eingekoppelt wird. Als Sendeeinheit 10 kann eine Laserdiode vorgesehen sein. Dem hier als Koppler 13 vorgesehenen Strahlteiler sind vorzugsweise nicht näher bezeichnete Kollimatorlinsen (Grin lenses) zum Kollimieren des von der Sendeeinheit 10 kommenden Meßlichts L einerseits und des aus dem Koppler 13 in den Lichtwellenleiter 50 eingekoppelten Meßlichts L andererseits zugeordnet. Als polarisationserhaltender Lichtwellenleiter 50 kann eine niedrigdoppelbrechende Lichtfaser (LoBi-Fibre) vorgesehen sein. Ein Spleiß 53 verbindet vorzugsweise den Lichtwellenleiter 50 mit der Meßwicklung des ersten Faraday-Elements 3. Das zweite Faraday-Element 4 und die zweite Auswerteeinheit 8 sind vorzugsweise ebenfalls über einen polarisationserhaltenden Lichtwellenleiter 60 optisch verbunden. Dieser Lichtwellenleiter 60 kann auch über einen Spleiß 64 mit der Meßwicklung des zweiten Faraday-Elements 4 verbunden sein und/oder als LoBi-Fibre ausgebildet sein.

Die beiden Auswerteeinheiten 7 und 8 sind analog aufgebaut wie in FIG. 6. In der ersten Auswerteeinheit 7 sind mit dem Koppler 13 optisch beispielsweise über eine Freistrahlanordnung oder auch einen Lichtwellenleiter gekoppelte Mittel 72 zum Aufteilen des zweimal durch das erste Faraday-Element 3 gelaufenen, reflektierten Lichtanteils LR in zwei linear polarisierte Teillichtsignale LR1 und LR2 mit unterschiedlichen Polarisationsebenen, photoelektrische Wandler 74 und 75 zum Umwandeln dieser Teillichtsignale LR1 und LR2 in jeweils ein elektrisches Signal R1 bzw. R2 als Maß für die Intensität des jeweiligen Teillichtsignals LR1 bzw. LR2 sowie elektronische Mittel 76 zum Ableiten des Meßsignals P aus diesen beiden elektrischen Signalen R1 und R2 vorgesehen. Die Ausgänge der photoelektrischen Wandler 74 und 75 sind jeweils mit einem Eingang der elektronischen Mittel 76 elektrisch verbunden. Die elektronischen Mittel 76 enthalten in einer bevorzugten Ausführungsform einen Analog-/Digital-Wandler 77 zum Digitalisieren der beiden Signale R1 und R2 und eine nachgeschaltete digitale Recheneinheit 78 zum Berechnen des Meßsignals P als Maß für vorzugsweise einen Überstrom im Stromleiter 2. Vorzugsweise wird in der Recheneinheit 78 zunächst ein Quotientsignal (R1-R2)/R1+R2) aus der Differenz R1-R2 und der Summe R1+R2 der beiden elektrischen Signale R1 und R2 berechnet. Dieses Quotientensignal ist von Intensitätsschwankungen der Sendeeinheit 10 oder in den Übertragungsstrecken weitgehend befreit und proportional zum cos(2 a) mit dem Faraday-Drehwinkel α. Das Meßsignal P als direktes Maß für den Strom I im Stromleiter 2 ergibt sich dann aus der Beziehung P = α/(2.Nₛ·Vₛ), wobei Nₛ die Anzahl der Windungen des ersten Faraday-Elements 3 und Vₛ die Verdet-Konstante des Materials des ersten Faraday-Elements 3 sind. Typischerweise ist Nₛ zwischen 1 und 3 für die Überstrommessung.

Die zweite Auswerteeinheit 8 enthält mit dem zweiten Faraday-Element 4 über den polarisationserhaltenden Lichtwellenleiter 60 optisch verbundene Mittel 82 zum Aufteilen des linear polarisierten transmittierten Lichtanteils LT in zwei linear polarisierte Teillichtsignale LT1 und LT2 mit unterschiedlichen Polarisationsebenen, photoelektrische Wandler 84 und 85 zum Umwandeln dieser Teillichtsignale LT1 und LT2 in jeweils ein elektrisches Signal T1 bzw. T2 als Maß für die Intensität des jeweiligen Lichtteilsignals LT1 bzw. LT2 und elektronische Mittel 86 zum Ableiten des Meßsignals M aus den beiden elektrischen Signale T1 und T2 vorgesehen. Die elektrischen Signale T1 und T2 an den Ausgängen der Wandler 84 und 85 werden wieder einem Analog-/Digital-Wandler 87 und einer nachgeschalteten digitalen Recheneinheit 88 zugeführt. Vorzugsweise wird in der Recheneinheit 88 ebenfalls zunächst ein intensitätsnormiertes Quotientensignal (T1-T2)/(T1+T2) aus der Differenz T1-T2 und der Summe T1+T2 der beiden elektrischen Signale T1 und T2 hergeleitet. Dieses Quotientensignal ist proportional zu cos(2β) mit dem Faraday-Gesamtdrehwinkel β des transmittierten polarisierten Lichtanteils LT. Das einem Strom I in dem Stromleiter 2 aus dem Nennstrombereich entsprechende Meßsignal M ergibt sich dann aus der Beziehung M = β/(Nₛ·Vₛ+N_{M}·V_{M}) mit der Windungszahl N_{M} und der Verdet-Konstanten V_{M} des zweiten Faraday-Elements 4. Die Windungszahl N_{M} des zweiten Faraday-Elements 4 wird im allgemeinen zwischen 10 und 50 gewählt.

Zusätzlich kann wegen der für Nennströme geforderten hohen Meßgenauigkeit ein Temperaturkompensationsverfahren durchgeführt werden.

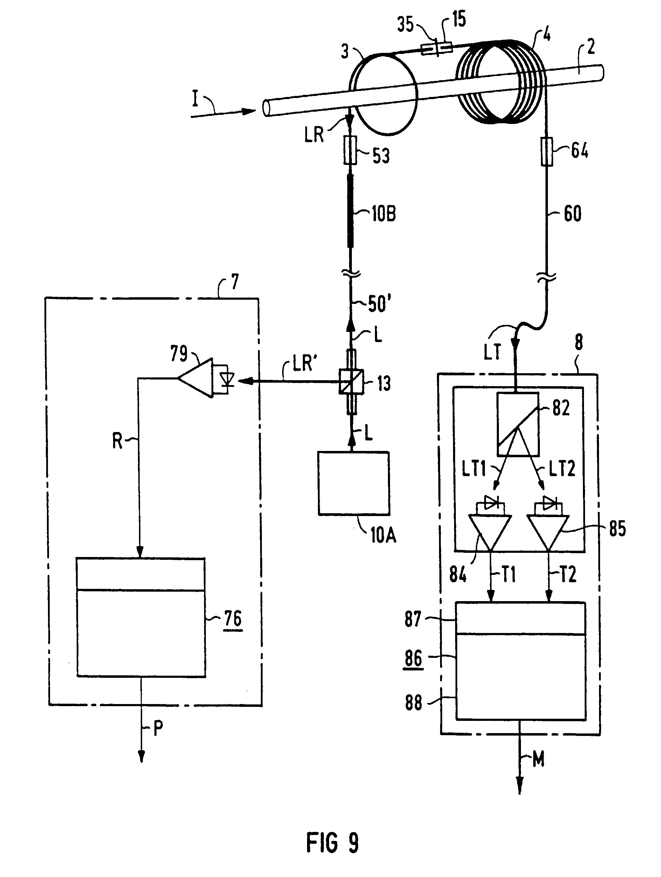

Eine Ausführungsform der Anordnung mit vereinfachter Signalauswertung für die Überstrommessung zeigt FIG. 9. Die Auswerteeinheit 7 enthält hier anstelle der Mittel 72 zum Aufteilen gemäß der in FIG. 8 dargestellten Ausführungsform polarisierende Mittel 10B, die optisch zwischen das erste Faraday-Element 3 und den Koppler 13 geschaltet sind, und einen Photodetektor 79, der optisch mit dem Koppler 13 gekoppelt ist und dessen Ausgang elektrisch mit den elektronischen Auswertemitteln 76 verbunden ist. Es ist eine Lichtquelle 10A zum Senden von Licht L vorgesehen, die optisch mit dem Koppler 13 gekoppelt ist. Der Koppler 13 kann über eine optische Faser 50' mit den polarisierenden Mitteln 10B verbunden sein. Diese Faser 50' kann in dieser Ausführungsform eine einfache Telekommunikationsfaser sein ohne polarisationserhaltende Eigenschaften, da die polarisierenden Mittel 10B das Licht L erst unmittelbar vor seinem Eintritt in die Serienschaltung der beiden Faraday-Elemente 3 und 4 am Eingang des ersten Faraday-Elements 3 linear polarisieren. Daher kann als Lichtquelle 10A auch eine nicht polarisierende, einfache Lichtquelle vorgesehen sein. Die polarisierenden Mittel 10B und die Lichtquelle 10A bilden gemeinsam die Sendeeinheit 10 zum Einkoppeln linear polarisierten Meßlichts L in das erste Faraday-Element 3. Für den von den teilreflektierenden Verbindungsmitteln 15 reflektierten, in seiner Polarisationsebene gedrehten Lichtanteil LR sind die polarisierenden Mittel 10B zugleich als Analysator vorgesehen. Der Analysator läßt nur den auf seine vorgegebene Polarisationsebene projizierten Anteil LR' des linear polarisierten Lichts LR durch. Der durch den Analysator hindurchgetretene linear polarisierte Lichtanteil LR' wird über den Koppler 13 dem Photodetektor 79 zugeführt und dort in ein elektrisches Meßsignal R umgewandelt. Dieses Meßsignal R ist proportional zu cos(α) mit dem Faraday-Drehwinkel α. Die Auswertemittel 76 ermitteln aus diesem Signal R ein Schutzsignal P als Maß für einen Überstrom in dem Stromleiter 2 gemäß der Beziehung P = α/(2·Nₛ·Vₛ). Ansonsten ist die in FIG. 9 gezeigte Meßanordnung wie in der Ausführungsform gemäß FIG. 8 aufgebaut.

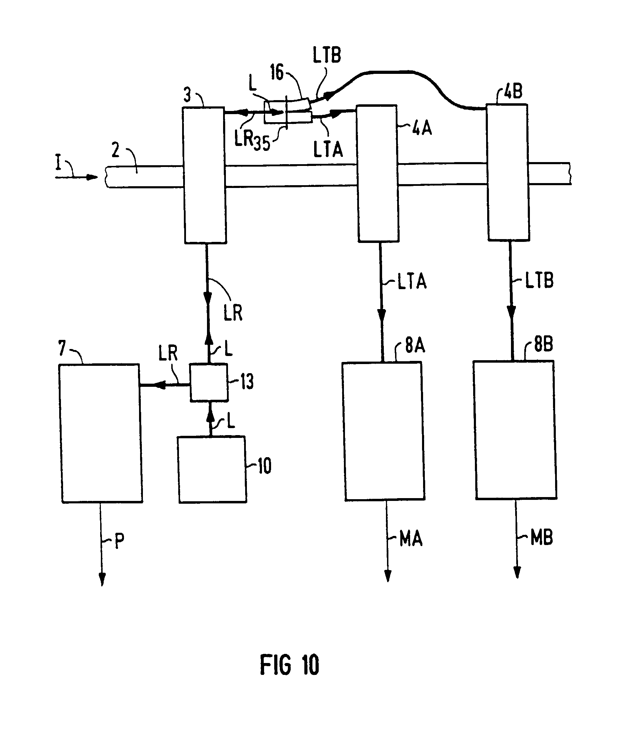

In der Ausführungsform der Meßanordnung gemäß FIG. 10 sind ein erstes Faraday-Element 3 und zwei weitere Faraday-Elemente 4A und 4B vorgesehen, die beide über gemeinsame optische Verbindungsmittel 16 mit dem ersten Faraday-Element 3 optisch in Reihe geschaltet sind und denen jeweils eine Auswerteeinheit 8A bzw. 8B zugeordnet ist. Als optische Verbindungsmittel 16 ist vorzugsweise ein teilreflektierender Y-Koppler vorgesehen. Die Auswerteeinheit 8A wertet den durch die Reihenschaltung von erstem Faraday-Element 3 und erstem weiteren Faraday-Element 4A transmittierten Lichtanteil LTA für ein Meßsignal MA aus, und die Auswerteeinheit 8B wertet den durch die Serienschaltung des ersten Faraday-Elements 3 mit dem zweiten weiteren Faraday-Element 4B transmittierten Lichtanteil LTB für ein weiteres Meßsignal MB aus. Durch entsprechende Wahl der Meßempfindlichkeiten der einzelnen weiteren Faraday-Elemente 4A und 4B kann in dieser Ausführungsform insbesondere der Gesamtmeßbereich der Anordnung für Nennströme erweitert werden.

Es können auch mehr als zwei weitere Faraday-Elemente vorgesehen sein, die jeweils mit dem ersten Faraday-Element 3 über gemeinsame optische Verbindungsmittel in Reihe geschaltet sind. Die optischen Verbindungsmittel können dann beispielsweise mit einem mechanischen Mehrfachspleiß und einem verspiegelten Ende der Faser des ersten Faraday-Elements ausgebildet sein.

Die optische Kopplung der verschiedenen optischen Komponenten der Meßanordnung wird vorzugsweise durch Kollimatorlinsen (Grin lenses) zum Bündeln des Meßlichts L und seiner Teile LR, LT, LTA und LTB unterstützt.

In einer besonderen, nicht dargestellten Ausführungsform können auch mehrere linear polarisierte Meßlichtsignale verschiedener und in der Regel nahe beieinanderliegender Wellenlängen in Verbindung mit wellenlängenempfindlichen optischen Verbindungsmitteln 14, 15, 16, 18, 19, 20, 22 oder 23 verwendet werden. Damit kann ein Übersprechen zwischen Schutz- und Meßkanal vermieden werden.

## Patentansprüche

1. Verfahren zum Messen von elektrischen Strömen aus wenigstens zwei Meßbereichen in einem Stromleiter (2) mit Hilfe von wenigstens zwei, dem Stromleiter (2) zugeordneten Faraday-Elementen (3, 4, 4A, 4B, 5), bei dem
a) linear polarisiertes Meßlicht (L) ein erstes der Faraday-Elemente (3) durchläuft und nach Durchlaufen des ersten Faraday-Elements (3) in wenigstens zwei Teile (LR und LT, L1 und L2, LR und LTA und LTB) aufgeteilt wird;
b) als Maß für einen Strom aus einem ersten Meßbereich die Faraday-Drehung von einem ersten der wenigstens zwei Teile (LR, L1) des Meßlichts (L), der nur durch das erste Faraday-Element (3) wenigstens einmal gelaufen ist, ausgewertet wird;
c) als Maß für einen Strom aus einem zweiten Meßbereich die Faraday-Drehung von einem zweiten der wenigstens zwei Teile (LT, L2, L2', L2A, L2B, LB1, LB2, LTA, LTB) des Meßlichts (L), der durch das erste Faraday-Element (3) und wenigstens ein zweites der Faraday-Elemente (4, 4A, 4B, 5) jeweils wenigstens einmal gelaufen ist, ausgewertet wird.

2. Verfahren nach Anspruch 1, bei dem als Maß für einen Strom aus einem dritten Meßbereich die Faraday-Drehung von einem dritten Teil (LTB, L2B) des Meßlichts (L), der durch das erste Faraday-Element (3) und ein drittes Faraday-Element (4B) jeweils wenigstens einmal gelaufen ist, ausgewertet wird.

3. Verfahren nach Anspruch 1, bei dem als Maß für einen Strom aus einem dritten Meßbereich die Faraday-Drehung von einem dritten Teil (LB2) des Meßlichts (L), der durch das erste Faraday-Element (3), das zweite Faraday-Element (4) und ein drittes Faraday-Element (5) jeweils wenigstens einmal gelaufen ist, ausgewertet wird.

4. Anordnung zum Messen von elektrischen Strömen aus wenigstens zwei Meßbereichen in einem Stromleiter (2) mit
a) wenigstens zwei, dem Stromleiter (2) zugeordneten Faraday-Elementen (3, 4, 4A, 4B, 5);
b) Mitteln (10) zum Einkoppeln von linear polarisiertem Meßlicht (L) in ein erstes der Faraday-Elemente (3);
c) optischen Verbindungsmitteln, über die das erste Faraday-Element (3) mit einem zweiten der Faraday-Elemente (4, 4A, 4B) optisch in Reihe geschaltet ist und die das durch das erste Faraday-Element (3) gelaufene Meßlicht (L) in einen ersten Teil (LR, L1)und wenigstens einen weiteren Teil (LT, LTA und LTB, L2) aufteilen;
d) einer ersten Auswerteeinheit (7) zum Auswerten der Faraday-Drehung der Polarisationsebene von dem ersten, nur durch das erste Faraday-Element (3) wenigstens einmal gelaufenen Teil (LR, L1) des linear polarisierten Meßlichts (L) als Maß für einen Strom aus einem ersten Meßbereich;
e) für jeden weiteren Meßbereich jeweils einer Auswerteeinheit (8, 8A, 8B, 9) zum Auswerten der Faraday-Drehung der Polarisationsebene von jeweils einem durch das erste Faraday-Element (3) und wenigstens ein weiteres Faraday-Element (4, 4A, 4B, 5) wenigstens einmal gelaufenen, weiteren Teil (LT, L2, L2', L2A, L2B, LB1, LB2, LTA, LTB) des Meßlichts (L) als Maß für einen Strom aus diesem weiteren Meßbereich.

5. Anordnung nach Anspruch 4, bei der
a) die optischen Verbindungsmittel (14, 15, 16) den ersten Teil (LR) des Meßlichts (L) nach dessen erstem Durchlaufen des ersten Faraday-Elements (3) in dieses erste Faraday-Element (3) zurückreflektieren und einen zweiten Teil (LT) in das zweite Faraday-Element (4, 4A) einkoppeln, und bei der
b) die erste Auswerteeinheit (7) die Faraday-Drehung des ersten Teils (LR) des Meßlichts (L) nach dessen nochmaligem Durchlaufen des ersten Faraday-Elements (3) auswertet.

6. Anordnung nach Anspruch 5, bei der die optischen Verbindungsmittel (14, 15, 16) einen teildurchlässigen und im wesentlichen senkrecht zur Ausbreitungsrichtung des Meßlichts (L) angeordneten Spiegel (35) enthalten.

7. Anordnung nach Anspruch 4, bei der die optischen Verbindungsmittel (18, 19, 20) den ersten Teil (L1, LA) des Meßlichts (L) nach einmaligem Durchlaufen des ersten Faraday-Elements (3) der ersten Auswerteeinheit (7) zuführen und einen weiteren Teil (L2, L2A, LB) des Meßlichts (L) in das zweite Faraday-Element (4, 4A) einkoppeln.

8. Anordnung nach Anspruch 7, bei der dem zweiten Faraday-Element (4) lichtreflektierende Mittel (40) zugeordnet sind, die den weiteren Teil (L2) des Meßlichts (L) nach einem ersten Durchlauf des zweiten Faraday-Elements (4) in das zweite Faraday-Element (4) zurückreflektieren.

9. Anordnung nach Anspruch 8, bei der die optischen Verbindungsmittel (19) das zweite Faraday-Element (4) und die zweite Auswerteeinheit (8) optisch miteinander verbinden und den von den lichtreflektierenden Mitteln (40) in das zweite Faraday-Element (4) zurückreflektierten weiteren Teil (L2') des Meßlichts (L) nach nochmaligem Durchlaufen des zweiten Faraday-Elements (4) einer zweiten Auswerteeinheit (8) zuführen.

10. Anordnung nach Anspruch 8, bei der eine zweite Auswerteeinheit (8) mit dem ersten Faraday-Element (3) optisch verbunden ist und die Faraday-Drehung des zurückreflektierten weiteren Teils (L2') des Meßlichts (L) nach nochmaligem Durchlaufen beider Faraday-Elemente (3, 4) auswertet.

11. Anordnung nach einem der Ansprüche 5 bis 7, bei der eine zweite Auswerteeinheit (8, 8A) die Faraday-Drehung des weiteren Teils (LT, LTA, L2, L2A, LB1) des Meßlichts (L) nach dessen einmaligem Durchlaufen des zweiten Faraday-Elements (4, 4A) als Maß für einen Strom aus einem zweiten Meßbereich auswertet.

12. Anordnung nach einem der Ansprüche 4 bis 11, bei der
a) ein drittes Faraday-Element (4B, 5) vorgesehen ist,
b) eine dritte Auswerteeinheit (8B, 9) die Faraday-Drehung von einem zumindest durch das erste Faraday-Element (3) und das dritte Faraday-Element (4B, 5) jeweils wenigstens einmal gelaufenen Teil (L2B, LB2, LTB) des Meßlichts (L) als Maß für einen Strom aus einem dritten Meßbereich auswertet.

13. Anordnung nach Anspruch 12, bei der das zweite Faraday-element (4A, 4) und das dritte Faraday-Element (4B, 5) unterschiedliche Meßempfindlichkeiten aufweisen.

14. Anordnung nach einem der Ansprüche 4 bis 13, bei der die Faraday-Elemente (3, 4, 4A, 4B, 5) jeweils mit einem Lichtwellenleiter gebildet sind, der den Stromleiter (2) jeweils in Form einer Wicklung mit wenigstens einer Windung umgibt.

15. Anordnung nach einem der Ansprüche 4 bis 13, bei der die Faraday-Elemente (3, 4, 4A, 4B, 5) jeweils mit einem massiven Ringkörper gebildet sind, der den Stromleiter (2) umgibt.

## Claims

1. Method for measuring electrical currents from at least two measuring ranges in a current conductor (2) with the aid of at least two Faraday elements (3, 4, 4A, 4B, 5) which are associated with the current conductor (2), in which method
a) linearly polarized measuring light (L) traverses a first of the Faraday elements (3) and after traversing the first Faraday element (3) is split into at least two components (LR and LT, L1 and L2, LR and LTA and LTB);
b) the Faraday rotation of a first of the at least two components (LR, L1) of the measuring light (L) which has traversed only the first Faraday element (3) at least once is evaluated as a measure of a current from a first measuring range;
c) the Faraday rotation of a second of the at least two components (LT, L2, L2', L2A, L2B, LB1, LB2, LTA, LTB) of the measuring light (L) which has traversed the first Faraday element (3) and at least a second of the Faraday elements (4, 4A, 4B, 5) at least once in each case is evaluated as a measure of a current from a second measuring range.

2. Method according to Claim 1, in which the Faraday rotation of a third component (LTB, L2B) of the measuring light (L) which has traversed the first Faraday element (3) and a third Faraday element (4B) at least once in each case is evaluated as a measure of a current from a third measuring range.

3. Method according to Claim 1, in which the Faraday rotation of a third component (LB2) of the measuring light (L) which has traversed the first Faraday element (3), the second Faraday element (4) and a third Faraday element (5) at least once in each case is evaluated as a measure of a current from a third measuring range.

4. Arrangement for measuring electrical currents from at least two measuring ranges in a current conductor (2) , comprising
a) at least two Faraday elements (3, 4, 4A, 4B, 5) associated with the current conductor (2);
b) means (10) for injecting linearly polarized measuring light (L) into a first of the Faraday elements (3);
c) optical connecting means via which the first Faraday element (3) is optically connected in series with a second of the Faraday elements (4, 4A, 4B) and which split the measuring light (L) which has traversed the first Faraday element (3) into a first component (LR, L1) and at least one further component (LT, LTA and LTB, L2);
d) a first evaluating unit (7) for evaluating the Faraday rotation of the plane of polarization of the first component (LR, L1) of the linearly polarized measuring light (L) which has traversed only the first Faraday element (3) at least once as a measure of a current from a first measuring range;
e) a respective evaluating unit (8, 8A, 8B, 9) for each further measuring range for evaluating the Faraday rotation of the plane of polarization of one further component (LT, L2, L2', L2A, L2B, LB1, LB2, LTA, LTB) in each case of the measuring light (L) which has traversed the first Faraday element (3) and at least one further Faraday element (4, 4A, 4B, 5) at least once as a measure of a current from said further measuring range.

5. Arrangement according to Claim 4, in which
a) the optical connecting means (14, 15, 16) reflect the first component (LR) of the measuring light (L) back into said first Faraday element (3) for the first time after it has traversed the first Faraday element (3) and inject a second component (LT) into the second Faraday element (4, 4A), and in which
b) the first evaluating unit (7) evaluates the Faraday rotation of the first component (LR) of the measuring light (L) after it has traversed the first Faraday element (3) again.

6. Arrangement according to Claim 5, in which the optical connecting means (14, 15, 16) contain a partially transparent mirror (35) disposed essentially perpendicularly to the direction of propagation of the measuring light (L).

7. Arrangement according to Claim 4, in which the optical connecting means (18, 19, 20) feed the first component (L1, LA) of the measuring light (L) to the first evaluating unit (7) after it has traversed the first Faraday element (3) once and inject a further component (L2, L2A, LB) of the measuring light (L) into the second Faraday element (4, 4A).

8. Arrangement according to Claim 7, in which there are associated with the second Faraday element (4) light-reflecting means 40 which reflect the further component (L2) of the measuring light (L) back into the second Faraday element (4) after a first passage through the second Faraday element (4).

9. Arrangement according to Claim 8, in which the optical connecting means (19) optically connect the second Faraday element (4) and the second evaluating unit (8) to one another and feed the further component (L2') of the measuring light (L) reflected back into the second Faraday element (4) by the light-reflecting means (40) to a second evaluating unit (8) after it has traversed the second Faraday element (4) again.

10. Arrangement according to Claim 8, in which a second evaluating unit (8) is optically connected to the first Faraday element (3) and evaluates the Faraday rotation of the further component (L2') of the measuring light (L) reflected back after it has traversed the two Faraday elements (3, 4) again.

11. Arrangement according to one of Claims 5 to 7, in which a second evaluating unit (8, 8A) evaluates the Faraday rotation of the further component (LT, LTA, L2, L2A, LB1) of the measuring light (L) after it has traversed the second Faraday element (4, 4A) once as a measure of a current from a second measuring range.

12. Arrangement according to one of Claims 4 to 11, in which
a) a third Faraday element (4B, 5) is provided,
b) a third evaluating unit (8B, 9) evaluates the Faraday rotation of a component (L2B, LB2, LTB) of the measuring light (L) which has traversed the first Faraday element (3) and the third Faraday element (4B, 5) at least once in each case as a measure of a current from a third measuring range.

13. Arrangement according to Claim 12, in which the second Faraday element (4A, 4) and the third Faraday element (4B, 5) have different measurement sensitivities.

14. Arrangement according to one of Claims 4 to 13, in which the Faraday elements (3, 4, 4A, 4B, 5) are each formed by an optical waveguide which surrounds the current conductor (2) in the form of a winding having at least one turn in each case.

15. Arrangement according to one of Claims 4 to 13, in which the Faraday elements (3, 4, 4A, 4B, 5) are each formed by a solid annular body which surrounds the current conductor (2).

## Revendications

1. Procédé pour mesurer des courants électriques dans au moins deux plages de mesure dans un conducteur de courant (2) à l'aide d'au moins deux éléments de Faraday (3, 4, 4A, 4B, 5) associés au conducteur de courant (2), dans lequel
a) on fait passer de la lumière de mesure (L) polarisée linéairement à travers un premier élément de Faraday (3) et, après passage du premier élément de Faraday (3), on la divise en au moins deux parties (LR et LT, L1 et L2, LR et LTA et LTB) ;
b) comme mesure pour un courant dans une première plage de mesure, on prend la rotation de Faraday d'une première partie qui est une des - au moins deux - parties (LR, L1) de la lumière de mesure (L) et qui n'est passée au moins une fois qu'à travers le premier élément de Faraday (3) ;
c) comme mesure pour un courant dans une deuxième plage de mesure, on prend la rotation de Faraday d'une deuxième partie qui est une des - au moins deux - parties (LT, L2, L2', L2A, L2B, LB1, LB2, LTA, LTB) de la lumière de mesure (L) et qui est passée au moins une fois à travers le premier élément de Faraday (3) et au moins une fois à travers au moins un deuxième élément de Faraday (4, 4A, 4B, 5).

2. Procédé selon la revendication 1, dans lequel on prend comme mesure pour un courant dans une troisième plage de mesure la rotation de Faraday d'une troisième partie (LTB, L2B), de la lumière de mesure (L), qui est passée au moins une fois à travers le premier élément de Faraday (3) et au moins une fois à travers un troisième élément de Faraday (4B).

3. Procédé selon la revendication 1, dans lequel on prend comme mesure pour un courant dans une troisième plage de mesure la rotation de Faraday d'une troisième partie (LB2), de la lumière de mesure (L), qui est passée au moins une fois à travers le premier élément de Faraday (3), au moins une fois à travers le deuxième élément de Faraday (4) et au moins une fois à travers un troisième élément de Faraday (5).

4. Dispositif pour mesurer des courants électriques dans au moins deux plages de mesure dans un conducteur de courant (2), comportant
a) au moins deux éléments de Faraday (3, 4, 4A, 4B, 5) associés au conducteur de courant (2) ;
b) des moyens (10) pour introduire de la lumière de mesure (L) polarisée linéairement dans un premier élément de Faraday (3) ;
c) des moyens de liaison optique par l'intermédiaire desquels le premier élément de Faraday (3) est placé optiquement en série avec un deuxième élément de Faraday (4, 4A, 4B) et la lumière de mesure (L) passée à travers le premier élément de Faraday (3) est divisée en une première partie (LR, L1) et au moins en une autre partie (LT, LTA et LTB, L2) ;
d) une première unité d'exploitation (7) pour exploiter comme mesure pour un courant dans une première plage de mesure la rotation de Faraday du plan de polarisation de la première partie (LR, L1), qui n'est passée au moins une fois qu'à travers le premier élément de Faraday (3), de la lumière de mesure (L) polarisée linéairement ;
e) pour chaque autre plage de mesure, respectivement une unité d'exploitation (8, 8A, 8B, 9) pour exploiter comme mesure pour un courant dans cette autre plage de mesure la rotation de Faraday du plan de polarisation respectivement d'une autre partie (LT, L2, L2', L2A, L2B, LB1, LB2, LTA, LTB), passée au moins une fois à travers le premier élément de Faraday (3) et à travers au moins un autre élément de Faraday (4, 4A, 4B, 5), de la lumière de mesure (L).

5. Dispositif selon la revendication 4, dans lequel
a) les moyens de liaison optique (14, 15, 16) réfléchissent la première partie (LR) de la lumière de mesure (L) après son premier passage à travers le premier élément de Faraday (3) dans ce premier élément de Faraday (3) et introduisent une deuxième partie (LT) dans le deuxième élément de Faraday (4, 4A), et
b) la première unité d'exploitation (7) exploite la rotation de Faraday de la première partie (LR) de la lumière de mesure (L) après son autre passage à travers le premier élément de Faraday (3).

6. Dispositif selon la revendication 5, dans lequel les moyens de liaison optique (14, 15, 16) comportent un miroir (35) partiellement transparent et sensiblement perpendiculaire à la direction de propagation de la lumière de mesure (L).

7. Dispositif selon la revendication 4, dans lequel les moyens de liaison optique (18, 19, 20) envoient la première partie (L1, LA) de la lumière de mesure (L), après un seul passage à travers le premier élément de Faraday (3), à l'unité d'exploitation (7) et introduisent une autre partie (L2, L2A, LB) de la lumière de mesure (L) dans le deuxième élément de Faraday (4, 4A).

8. Dispositif selon la revendication 7, dans lequel des moyens (40) réfléchissant la lumière sont associés au deuxième élément de Faraday (4) et réfléchissent l'autre partie (L2) de la lumière de mesure (L), après un premier passage à travers le deuxième élément de Faraday (4), dans le deuxième élément de Faraday (4).

9. Dispositif selon la revendication 8, dans lequel les moyens de liaison optique (19) relient optiquement le deuxième élément de Faraday (4) et la deuxième unité d'exploitation (8) et envoient l'autre partie (L2'), réfléchie dans le deuxième élément de Faraday (4) par les moyens (40) réfléchissant la lumière, de la lumière de mesure (L), après un autre passage à travers le deuxième élément de Faraday (4), à une deuxième unité d'exploitation (8).

10. Dispositif selon la revendication 8, dans lequel une deuxième unité d'exploitation (8) est reliée optiquement au premier élément de Faraday (3) et exploite la rotation de Faraday de l'autre partie réfléchie (L2') de la lumière de mesure (L), après un autre passage à travers les deux éléments de Faraday (3, 4).

11. Dispositif selon l'une des revendications 5 à 7, dans lequel une deuxième unité d'exploitation (8, 8A) exploite comme mesure pour un courant dans une deuxième plage de mesure la rotation de Faraday de l'autre partie (LT, LTA, L2, L2A, LB1) de la lumière de mesure (L), après son unique passage à travers le deuxième élément de Faraday (4, 4A).

12. Dispositif selon l'une des revendications 4 à 11, dans lequel
a) un troisième élément de Faraday (4B, 5) est prévu,
b) une troisième unité d'exploitation (8B, 9) exploite comme mesure pour un courant dans une troisième plage de mesure la rotation de Faraday d'une partie (L2B, LB2, LTB), passée au moins une fois à travers le premier élément de Faraday (3) et au moins une fois à travers le troisième élément de Faraday (4B, 5), de la lumière de mesure (L).

13. Dispositif selon la revendication 12, dans lequel le deuxième élément de Faraday (4A, 4) et le troisième élément de Faraday (4B, 5) ont des sensibilités de mesurage différentes.

14. Dispositif selon l'une des revendications 4 à 13, dans lequel les éléments de Faraday (3, 4, 4A, 4B, 5) sont formés chacun d'un guide d'ondes lumineuses, qui entoure le conducteur de courant (2) sous la forme d'un enroulement comportant au moins une spire.

15. Dispositif selon l'une des revendications 4 à 13, dans lequel les éléments de Faraday (3, 4, 4A, 4B, 5) sont formés chacun d'un corps annulaire plein qui entoure le conducteur de courant (2).
